# EUROPEAN PATENT SPECIFICATION

(11) **EP 3 161 874 B1**
(45) Date of publication and mention of the grant of the patent: **10.04.2019**
(21) Application number: 15812793.6
(22) Date of filing: 25.06.2015
(51) Int. Cl.: H01L 31/0216, H01L 31/0288, H01L 31/0232, H01L 31/18, H01L 31/0747, H01L 31/0236, H01L 31/068, H01L 31/0745

(54) **PASSIVATION OF LIGHT-RECEIVING SURFACES OF SOLAR CELLS WITH CRYSTALLINE SILICON**
PASSIVIERUNG VON LICHTAUFNEHMENDEN OBERFLÄCHEN VON SOLARZELLEN MIT KRISTALLINEM SILICIUM
PASSIVATION DE SURFACES DE RÉCEPTION DE LUMIÈRE DE CELLULES SOLAIRES À SILICIUM CRISTALLIN

(30) Priority: 27.06.2014 US 201414317672
(43) Date of publication of application: 03.05.2017
(73) Proprietor: SunPower Corporation, San Jose, CA 95134 (US); Total Marketing Services, 92800 Puteaux (FR)
(72) Inventor: JOHNSON, Michael C., Alameda, California 94501 (US); TRACY, Kieran Mark, San Jose, California 95126 (US); TOMADA, Princess Carmi, 4024 Binan Laguna (PH); SMITH, David D., Campbell, California 95008 (US); RIM, Seung Bum, Palo Alto, California 94304 (US); JAFFRENNOU, Périne, San Francisco, California 94107 (US)
(74) Representative: Grünecker Patent- und Rechtsanwälte PartG mbB
(86) International application number: PCT/US2015/037819
(87) International publication number: WO 2015/200715

(56) References cited:
- US-A- 4 642 414
- US-A- 5 030 295
- US-A1- 2010 258 168
- US-A1- 2012 055 547
- US-A1- 2012 055 547
- US-A1- 2012 199 183
- US-A1- 2012 222 731
- US-A1- 2012 301 999
- US-A1- 2013 112 253
- US-B1- 7 468 485

## Description

### TECHNICAL FIELD

Embodiments of the present disclosure are in the field of renewable energy and, in particular, methods of passivating light-receiving surfaces of solar cells with crystalline silicon, and the resulting solar cells.

### BACKGROUND

US 5 030 295 A relates to a radiation resistant passivation of a silicon solar cell. US 7 468 485 A relates to a back side contact solar cell with doped polysilicon regions. US 4 642 414 A relates to a solar cell having an amorphous or microcrystalline silicon layer. Photovoltaic cells, commonly known as solar cells, are well known devices for direct conversion of solar radiation into electrical energy. Generally, solar cells are fabricated on a semiconductor wafer or substrate using semiconductor processing techniques to form a p-n junction near a surface of the substrate. Solar radiation impinging on the surface of, and entering into, the substrate creates electron and hole pairs in the bulk of the substrate. The electron and hole pairs migrate to p-doped and n-doped regions in the substrate, thereby generating a voltage differential between the doped regions. The doped regions are connected to conductive regions on the solar cell to direct an electrical current from the cell to an external circuit coupled thereto. Efficiency is an important characteristic of a solar cell as it is directly related to the capability of the solar cell to generate power. Likewise, efficiency in producing solar cells is directly related to the cost effectiveness of such solar cells. Accordingly, techniques for increasing the efficiency of solar cells, or techniques for increasing the efficiency in the manufacture of solar cells, are generally desirable. Some embodiments of the present disclosure allow for increased solar cell manufacture efficiency by providing novel processes for fabricating solar cell structures. Some embodiments of the present disclosure allow for increased solar cell efficiency by providing novel solar cell structures.

### SUMMARY OF INVENTION

A solar cell and a method of fabricating a solar cell according to the invention are defined in the independent claims 1 and 9. Further advantageous embodiments are defined in the dependent claims.

### BRIEF DESCRIPTION OF THE DRAWINGS

Figures 1A-1E illustrate cross-sectional views of various stages in the fabrication of a solar cell, in accordance with an embodiment of the present disclosure, wherein:
Figure 1A illustrates a starting substrate of a solar cell;
Figure 1B illustrates the structure of Figure 1A following formation of a passivating dielectric layer on a light-receiving surface of the substrate;
Figure 1C illustrates the structure of Figure 1B following formation of an intrinsic silicon layer on the passivating dielectric layer;
Figure 1D illustrates the structure of Figure 1C following formation of an N-type silicon layer on the intrinsic silicon layer; and
Figure 1E illustrates the structure of Figure 1D following formation of an anti-reflective coating (ARC) layer on the N-type silicon layer.
Figure 2 is a flowchart listing operations in a method of fabricating a solar cell as corresponding to Figures 1A-1E, in accordance with an embodiment of the present disclosure.
Figure 3 illustrates a cross-sectional view of a back-contact solar cell having emitter regions formed above a back surface of a substrate and having a first exemplary stack of layers on a light-receiving surface of the substrate, in accordance with an embodiment of the present disclosure.
Figure 4 illustrates a cross-sectional view of a back-contact solar cell having emitter regions formed in a back surface of a substrate and having the first exemplary stack of layers on a light-receiving surface of the substrate, in accordance with an embodiment of the present disclosure.
Figure 5 is an energy band diagram for the first exemplary stack of layers disposed on a light-receiving surface of the solar cells described in association with Figures 3 and 4, in accordance with an embodiment of the present disclosure.
Figure 6A illustrates a cross-sectional view of a back-contact solar cell having emitter regions formed above a back surface of a substrate and having a second exemplary stack of layers on a light-receiving surface of the substrate, in accordance with an embodiment of the present disclosure.
Figure 6B is an energy band diagram for the second exemplary stack of layers disposed on a light-receiving surface of the solar cell described in association with Figure 6A, in accordance with an embodiment of the present disclosure.
Figure 7A illustrates a cross-sectional view of a back-contact solar cell having emitter regions formed above a back surface of a substrate and having a third exemplary stack of layers on a light-receiving surface of the substrate. Figure 7A is not part of the present invention.
Figure 7B is an energy band diagram for the third exemplary stack of layers disposed on a light-receiving surface of the solar cell described in association with Figure 7A. Figure 7B is not part of the present invention.

### DETAILED DESCRIPTION

The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Terminology. The following paragraphs provide definitions and/or context for terms found in this disclosure (including the appended claims):

"Comprising." This term is open-ended. As used in the appended claims, this term does not foreclose additional structure or steps.

"Configured To." Various units or components may be described or claimed as "configured to" perform a task or tasks. In such contexts, "configured to" is used to connote structure by indicating that the units/components include structure that performs those task or tasks during operation. As such, the unit/component can be said to be configured to perform the task even when the specified unit/component is not currently operational (e.g., is not on/active).

"First," "Second," etc. As used herein, these terms are used as labels for nouns that they precede, and do not imply any type of ordering (e.g., spatial, temporal, logical, etc.). For example, reference to a "first" solar cell does not necessarily imply that this solar cell is the first solar cell in a sequence; instead the term "first" is used to differentiate this solar cell from another solar cell (e.g., a "second" solar cell).

"Coupled" - The following description refers to elements or nodes or features being "coupled" together. As used herein, unless expressly stated otherwise, "coupled" means that one element/node/feature is directly or indirectly joined to (or directly or indirectly communicates with) another element/node/feature, and not necessarily mechanically.

"Inhibit" - As used herein, inhibit is used to describe a reducing or minimizing effect. When a component or feature is described as inhibiting an action, motion, or condition it may completely prevent the result or outcome or future state completely. Additionally, "inhibit" can also refer to a reduction or lessening of the outcome, performance, and/or effect which might otherwise occur. Accordingly, when a component, element, or feature is referred to as inhibiting a result or state, it need not completely prevent or eliminate the result or state.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Methods of passivating light-receiving surfaces of solar cells with crystalline silicon, and the resulting solar cells, are described herein. In the following description, numerous specific details are set forth, such as specific process flow operations, in order to provide a thorough understanding of embodiments of the present disclosure. It will be apparent to one skilled in the art that embodiments of the present disclosure may be practiced without these specific details. In other instances, well-known fabrication techniques, such as lithography and patterning techniques, are not described in detail in order to not unnecessarily obscure embodiments of the present disclosure. Furthermore, it is to be understood that the various embodiments shown in the figures are illustrative representations and are not necessarily drawn to scale.

Disclosed herein is a solar cell according to claim 1.

Also disclosed herein is a method of fabricating a solar cell according to claim 9.

One or more embodiments described herein are directed to approaches for achieving improved front surface field (FSF) performance for solar cells. In one embodiment, improved FSF performance is achieved using a crystalline silicon (Si) interlayer to provide improved efficiency and reliability.

To provide context, light induced degradation (LID) and/or ultra-violet (UV) degradation pose long standing issues for the long term stability of solar cell performance. High efficiency solar cells are especially subject to such degradation modes due to their increased sensitivity of the front surface passivation. Efforts have been exerted in improving the stability of such solar cells without compromising performance in the form of decreased passivation or solar spectrum absorption (e.g., Jsc loss). Performance stability may be critical for performance guarantees and for product quality differentiation. More particularly, front surface passivation can be critical for performance of high efficiency solar cells. Typically, front surface passivation is performed using a diffusion process followed by a high temperature oxidation and, finally, capping with an antireflection coating (ARC) using plasma-enhanced chemical vapor deposition (PECVD). Silicon nitride (SiN or SiN:H) is commonly used as an ARC due to its optical properties and also for its excellent passivation qualities. A silicon nitride layer may be used to provide H+ to a crystalline silicon/thermal oxide (c-Si/TOX) interface. Unfortunately, the interface can be degraded by long term exposure to UV light via hot electron injection across the interface which breaks existing Si-H bonds. The hot electron can be trapped in the subsequent layers and be re-excited to bounce back and forth across the interface, which is a process known as interface wear.

Addressing one or more of the above issues, in accordance with one or more embodiments described herein, efficiency and reliability of a solar cell are improved by inserting a crystallized silicon (Si) interlayer between a passivating oxide layer and an ARC layer, such as a SiN or SiN:H layer. In one embodiment, by inserting a crystallized or partially crystallized Si interlayer between the thermal oxide and SiN or SiN:H ARC layer, passivation and stability of the c-Si/TOX interface are improved. Additionally, an increase in Jsc may be achieved for the solar cell by using a more transparent interlayer. Such an interlayer may be deposited by a number of suitable methods. In one embodiment, direct deposition of a micro- or poly-crystalline N-type silicon (µc-Si:n) layer or polycrystalline Si:n layer is performed. In another embodiment, post-processing is performed to first deposit an amorphous N-type silicon (aSi:n) layer and then using an anneal process to crystallize the deposited layer. Post-processing may be performed with or without the ARC layer being present.

Not to be bound by theory, in an embodiment, improved stability achieved by direct deposition or phase conversion to a more crystallized phase improves the stress state of the N-type silicon interlayer which counter balances the compressive nature of the underlying thermal oxide. The result is a more energetically favorable Si-O bonding scenario. Additionally, converting to a crystallized state may reduce the total number of O-H bonds at the surface of the underlying thermal oxide, reducing the amount of trap states for hot electron trapping and resulting in decreased interface wear.

More generally, in accordance with one or more embodiments, an intrinsic microcrystalline or amorphous silicon:N-type micro- or poly-crystalline silicon (represented as i:n) structure is fabricated with or without a thin oxide for improved passivation. In another embodiment, the N-type micro- or poly-crystalline silicon layer can be used alone, so long as the thin oxide is of sufficiently high quality to maintain good passivation. In cases where an intrinsic micro- or poly-crystalline or amorphous silicon is implemented, the material provides an additional passivation protection for cases suffering from a defective oxide. In some embodiments, inclusion of a phosphorous-doped micro- or poly-crystalline silicon layer in addition to the intrinsic layer improves stability against UV degradation. The phosphorous-doped layer can be implemented to enable band-bending which aids in shielding the interface by repelling the minority carriers reducing the amount of recombination.

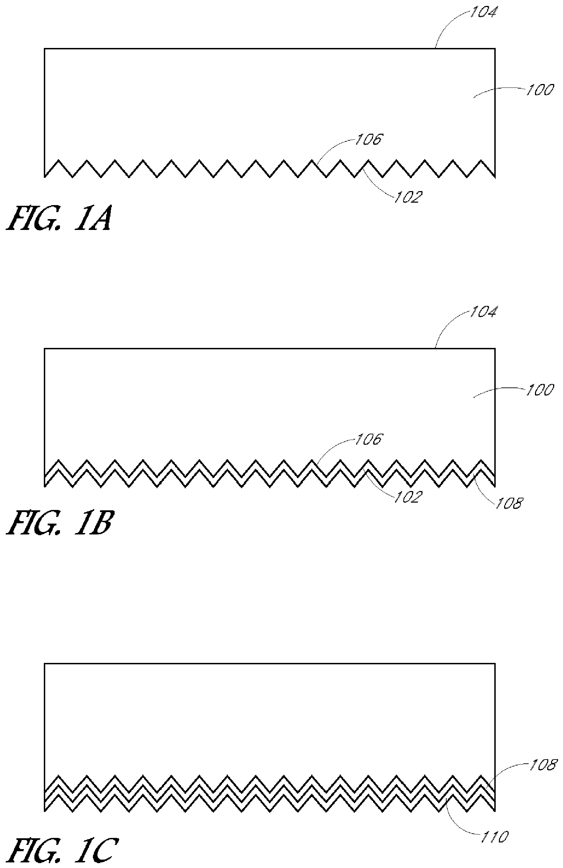

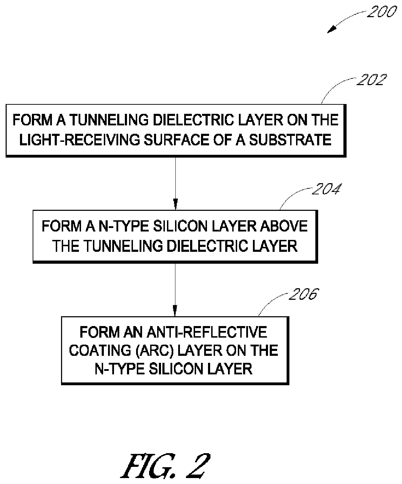

Figures 1A-1E illustrate cross-sectional views of various stages in the fabrication of a solar cell, in accordance with an embodiment of the present disclosure. Figure 2 is a flowchart listing operations in a method of fabricating a solar cell as corresponding to Figures 1A-1E, in accordance with an embodiment of the present disclosure.

Figure 1A illustrates a starting substrate of a solar cell. Referring to Figure 1A, substrate 100 has a light-receiving surface 102 and a back surface 104. In an embodiment, the substrate 100 is a monocrystalline silicon substrate, such as a bulk single crystalline N-type doped silicon substrate. It is to be appreciated, however, that substrate 100 may be a layer, such as a multi-crystalline silicon layer, disposed on a global solar cell substrate. In an embodiment, the light-receiving surface 102 has a texturized topography 106. In one such embodiment, a hydroxide-based wet etchant is employed to texturize the front surface of the substrate 100. It is to be appreciated that a texturized surface may be one which has a regular or an irregular shaped surface for scattering incoming light, decreasing the amount of light reflected off of the light-receiving surfaces of the solar cell.

Figure 1B illustrates the structure of Figure 1A following formation of a passivating dielectric layer on a light-receiving surface of the substrate. Referring to Figure 1B and corresponding operation 202 of flowchart 200, a passivating dielectric layer 108 is formed on the light-receiving surface 102 of substrate 100. In one embodiment, the light-receiving surface 102 has a texturized topography 106, and the passivating dielectric layer 108 is conformal with the texturized topography 106, as is depicted in Figure 1B.

In an embodiment, the passivating dielectric layer 108 is a layer of silicon dioxide (SiO₂). In one such embodiment, the layer of silicon dioxide (SiO₂) has a thickness approximately in the range of 10-200 Angstroms. In one embodiment, the passivating dielectric layer 108 is hydrophilic. In an embodiment, the passivating dielectric layer 108 is formed by a technique such as, but not limited to, chemical oxidation of a portion of the light-receiving surface of the silicon substrate, plasma-enhanced chemical vapor deposition (PECVD) of silicon dioxide (SiO₂), thermal oxidation of a portion of the light-receiving surface of the silicon substrate, atomic layer deposition (ALD) of SiO₂ or AlOx, or exposure of the light-receiving surface of the silicon substrate to ultra-violet (UV) radiation in an O₂ or O₃ environment.

Figure 1C illustrates the structure of Figure 1B following formation of an intrinsic silicon layer on the passivating dielectric layer. Referring to Figure 1C, an intrinsic silicon layer 110 is formed on the passivating dielectric layer 108. In one embodiment, as is depicted in Figure 1C, the intrinsic silicon layer 110 is conformal with the texturized topography 106.

In an embodiment, the intrinsic silicon layer 110 is an intrinsic micro- or poly-crystalline silicon layer. In one such embodiment, the intrinsic micro- or poly-crystalline silicon layer has a thickness approximately in the range of 1-5 nanometers. In one embodiment, the intrinsic micro- or poly-crystalline silicon layer has a crystalline fraction approximately in the range of 0.1-0.9 (i.e., 10-90%), with the balance being amorphous. In one embodiment, the intrinsic micro- or poly-crystalline silicon layer includes small grains having a micro or nano-diameter. The small grains may be embedded in a generally amorphous silicon matrix and have essentially no long range order.

In an embodiment, the intrinsic micro- or poly-crystalline silicon layer is formed by depositing an intrinsic amorphous silicon layer and, subsequently, phase converting the intrinsic amorphous silicon layer to the intrinsic micro- or poly-crystalline silicon layer. In one such embodiment, the intrinsic amorphous silicon layer is formed by a deposition process such as, but not limited to, plasma-enhanced chemical vapor deposition (PECVD), low pressure chemical vapor deposition (LPCVD), or sputtering (physical vapor deposition, PVD). In one embodiment, the phase conversion is achieved using a technique such as, but not limited to, heating in a furnace, rapid thermal processing (RTP), laser annealing, or forming gas annealing (FGA). In another embodiment, the intrinsic micro- or poly-crystalline silicon layer is formed by depositing the intrinsic micro- or poly-crystalline silicon layer. In one such embodiment, the intrinsic micro- or poly-crystalline silicon layer is deposited using PECVD.

In another embodiment, the intrinsic silicon layer 110 is an intrinsic amorphous silicon layer. In one such embodiment, the intrinsic amorphous silicon layer has a thickness approximately in the range of 1-5 nanometers. In one embodiment, forming the intrinsic amorphous silicon layer on the passivating dielectric layer 108 is performed at a temperature less than approximately 400 degrees Celsius. In an embodiment, the intrinsic amorphous silicon layer is formed using plasma enhanced chemical vapor deposition (PECVD), represented by a-Si:H, which includes Si-H covalent bonds throughout the layer.

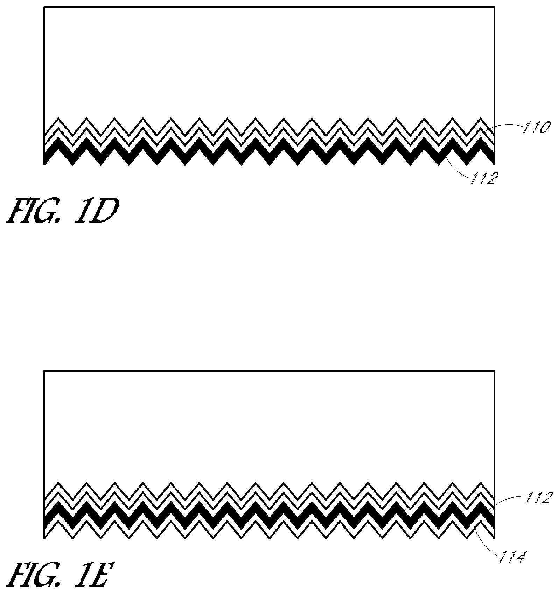

Figure 1D illustrates the structure of Figure 1C following formation of an N-type silicon layer on the intrinsic silicon layer. Referring to Figure 1D and corresponding operation 204 of flowchart 200, an N-type silicon layer 112 is formed on the intrinsic silicon layer 110. In one embodiment, as is depicted in Figure 1D, the N-type silicon layer 112 is conformal with the texturized topography 106.

In an embodiment, the N-type silicon layer 112 is an N-type micro- or poly-crystalline silicon layer. In one such embodiment, the intrinsic micro- or poly-crystalline silicon layer has a thickness approximately in the range of 1-20 nanometers. In one embodiment, the N-type micro- or poly-crystalline silicon layer has a crystalline fraction approximately in the range of 0.1-0.9 (i.e., 10-90%), with the balance being amorphous. In an embodiment, a concentration of N-type dopants (e.g., phosphorous) in the N-type micro- or poly-crystalline silicon layer is approximately in the range of 1E17 - 1E20 atoms/cm³. In one embodiment, the N-type micro- or poly-crystalline silicon layer includes small grains having a micro- or nano-diameter. The small grains may be embedded in a generally amorphous silicon matrix and have essentially no long range order. In an embodiment, the N-type dopants are included in the amorphous portion, in the crystalline portion, or both.

In an embodiment, the N-type micro- or poly-crystalline silicon layer is formed by depositing an N-type amorphous silicon layer and, subsequently, phase converting the N-type amorphous silicon layer to the N-type micro- or poly-crystalline silicon layer. In one such embodiment, the N-type amorphous silicon layer is formed by a deposition process such as, but not limited to, plasma-enhanced chemical vapor deposition (PECVD), low pressure chemical vapor deposition (LPCVD), or sputtering (physical vapor deposition, PVD). In one embodiment, the phase conversion is achieved using a technique such as, but not limited to, heating in a furnace, rapid thermal processing (RTP), laser annealing, or forming gas annealing (FGA). In another embodiment, the N-type micro- or poly-crystalline silicon layer is formed by depositing the N-type micro- or poly-crystalline silicon layer. In one such embodiment, the N-type micro- or poly-crystalline silicon layer is deposited using PECVD.

In another embodiment, the N-type silicon layer 112 is an N-type amorphous silicon layer. In one embodiment, forming the N-type amorphous silicon layer on the intrinsic silicon layer 110 is performed at a temperature less than approximately 400 degrees Celsius. In an embodiment, the N-type amorphous silicon layer is formed using plasma enhanced chemical vapor deposition (PECVD), represented by phosphorous-doped a-Si:H, which includes Si-H covalent bonds throughout the layer.

In either case, in an embodiment, the micro- or poly-crystalline or amorphous N-type silicon layer 112 includes an impurity such as phosphorous dopants. In one such embodiment, the phosphorous dopants are incorporated either during film deposition or in a post implantation operation.

With reference again to Figure 1D, in a first embodiment, the intrinsic silicon layer 110 is an amorphous intrinsic silicon layer, and the N-type silicon layer 112 is a micro- or poly-crystalline N-type silicon layer. In a second embodiment, the intrinsic silicon layer 110 is a micro- or poly-crystalline intrinsic silicon layer, and the N-type silicon layer 112 is an amorphous N-type silicon layer. In a third embodiment, the intrinsic silicon layer 110 is a micro- or poly-crystalline intrinsic silicon layer, and the N-type silicon layer 112 is a micro- or poly-crystalline N-type silicon layer.

Figure 1E illustrates the structure of Figure 1D following formation of an anti-reflective coating (ARC) layer on the N-type silicon layer. Referring to Figure 1E and corresponding operation 206 of flowchart 200, an anti-reflective coating (ARC) layer 114 is formed on the N-type silicon layer 112. In one embodiment, as is depicted in Figure 1E, the ARC layer 114 is conformal with the texturized topography 106.

In an embodiment, the ARC layer 114 is a non-conductive ARC layer. In one such embodiment, the non-conductive ARC layer includes silicon nitride. In a particular such embodiment, the silicon nitride is formed at a temperature less than approximately 400 degrees Celsius. In another embodiment, the ARC layer 114 is a conductive ARC layer. In one such embodiment, the conductive ARC layer includes a layer of indium tin oxide (ITO).

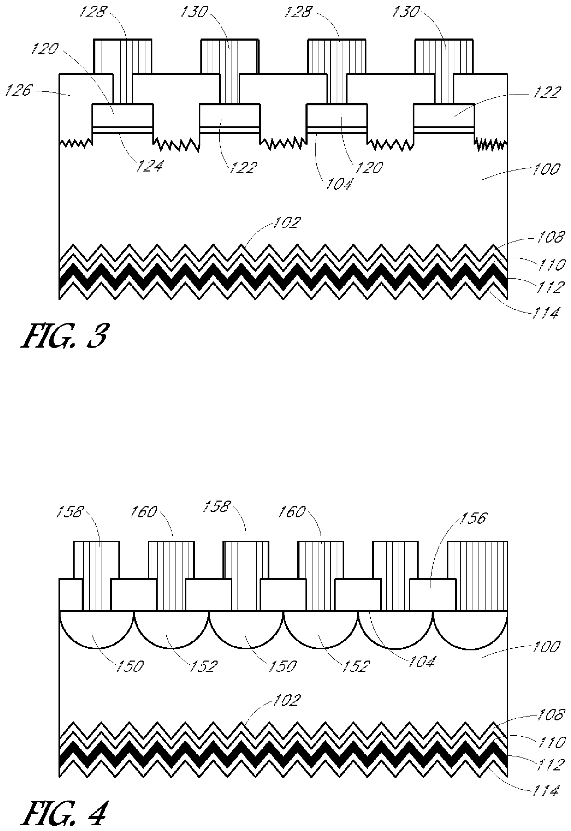

Figure 3 illustrates a cross-sectional view of a back-contact solar cell having emitter regions formed above a back surface of a substrate and having a first exemplary stack of layers on a light-receiving surface of the substrate, in accordance with an embodiment of the present disclosure.

Referring to Figure 3, a solar cell includes a silicon substrate 100 having a light-receiving surface 102. A passivating dielectric layer 108 is disposed on the light-receiving surface of the silicon substrate 100. An intrinsic silicon layer 110 is disposed on the passivating dielectric layer 108. An N-type silicon layer 112 is disposed on the intrinsic silicon layer 110. An anti-reflective coating (ARC) layer 114 is disposed on the N-type silicon layer 112. As such, the stack of layers on the light-receiving surface of the solar cell of Figure 3 is the same as that described in association with Figure 1A-1E.

With reference again to Figure 3, in a first embodiment, the intrinsic silicon layer 110 is an amorphous intrinsic silicon layer, and the N-type silicon layer 112 is a micro- or poly-crystalline N-type silicon layer. In a second embodiment, the intrinsic silicon layer 110 is a micro- or poly-crystalline intrinsic silicon layer, and the N-type silicon layer 112 is an amorphous N-type silicon layer. In a third embodiment, the intrinsic silicon layer 110 is a micro- or poly-crystalline intrinsic silicon layer, and the N-type silicon layer 112 is a micro- or poly-crystalline N-type silicon layer.

Referring again to Figure 3, on the back surface of the substrate 100, alternating P-type 120 and N-type 122 emitter regions are formed. In one such embodiment, trenches 121 are disposed between the alternating P-type 120 and N-type 122 emitter regions. More particularly, in an embodiment, first polycrystalline silicon emitter regions 122 are formed on a first portion of a thin dielectric layer 124 and are doped with an N-type impurity. Second polycrystalline silicon emitter regions 120 are formed on a second portion of the thin dielectric layer 124 and are doped with a P-type impurity. In an embodiment the tunnel dielectric 124 is a silicon oxide layer having a thickness of approximately 2 nanometers or less.

Referring again to Figure 3, conductive contact structures 128/130 are fabricated by first depositing and patterning an insulating layer 126 to have openings and then forming one or more conductive layers in the openings. In an embodiment, the conductive contact structures 128/130 include metal and are formed by a deposition, lithographic, and etch approach or, alternatively, a printing or plating process or, alternatively, a foil adhesion process.

Figure 4 illustrates a cross-sectional view of a back-contact solar cell having emitter regions formed in a back surface of a substrate and having the first exemplary stack of layers on a light-receiving surface of the substrate, in accordance with an embodiment of the present disclosure.

Referring to Figure 4, a solar cell includes a silicon substrate 100 having a light-receiving surface 102. A passivating dielectric layer 108 is disposed on the light-receiving surface of the silicon substrate 100. An intrinsic silicon layer 110 is disposed on the passivating dielectric layer 108. An N-type silicon layer 112 is disposed on the intrinsic silicon layer 110. An anti-reflective coating (ARC) layer 114 is disposed on the N-type silicon layer 112. As such, the stack of layers on the light-receiving surface of the solar cell of Figure 4 is the same as that described in association with Figure 1A-1E.

With reference again to Figure 4, in a first embodiment, the intrinsic silicon layer 110 is an amorphous intrinsic silicon layer, and the N-type silicon layer 112 is a micro- or poly-crystalline N-type silicon layer. In a second embodiment, the intrinsic silicon layer 110 is a micro- or poly-crystalline intrinsic silicon layer, and the N-type silicon layer 112 is an amorphous N-type silicon layer. In a third embodiment, the intrinsic silicon layer 110 is a micro- or poly-crystalline intrinsic silicon layer, and the N-type silicon layer 112 is a micro- or poly-crystalline N-type silicon layer.

Referring again to Figure 4, within the back surface of the substrate 100, alternating P-type 150 and N-type 152 emitter regions are formed. More particularly, in an embodiment, first emitter regions 152 are formed within a first portion of substrate 100 and are doped with an N-type impurity. Second emitter regions 150 are formed within a second portion of substrate 100 and are doped with a P-type impurity. Referring again to Figure 4, conductive contact structures 158/160 are fabricated by first depositing and patterning an insulating layer 156 to have openings and then forming one or more conductive layers in the openings. In an embodiment, the conductive contact structures 158/160 include metal and are formed by a deposition, lithographic, and etch approach or, alternatively, a printing or plating process or, alternatively, a foil adhesion process.

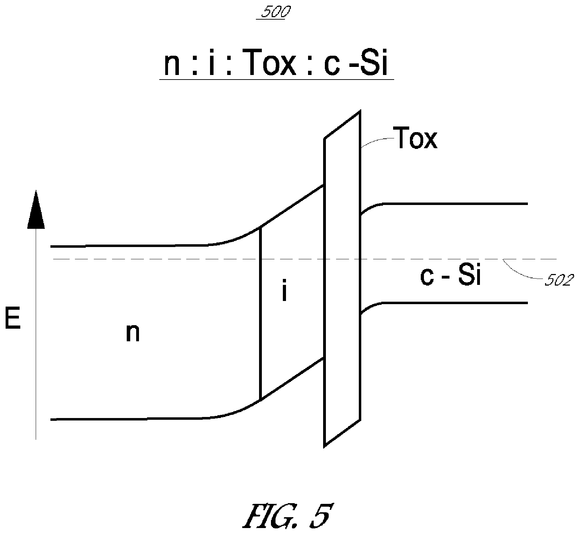

Figure 5 is an energy band diagram 500 for the first exemplary stack of layers disposed on a light-receiving surface of the solar cells described in association with Figures 3 and 4, in accordance with an embodiment of the present disclosure. Referring to the energy band diagram 500, a band structure is provided for a material stack including N-type doped silicon (n), intrinsic silicon (i), a thin oxide layer (Tox), and the crystalline silicon substrate (c-Si). The Fermi level is shown at 502 and reveals good passivation of the light-receiving surface of a substrate having this material stack.

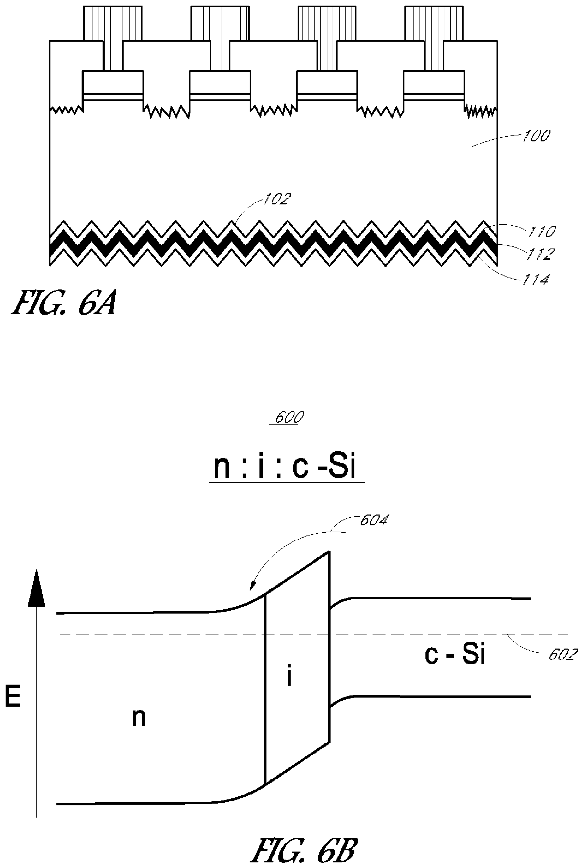

Figure 6A illustrates a cross-sectional view of a back-contact solar cell having emitter regions formed above a back surface of a substrate and having a second exemplary stack of layers on a light-receiving surface of the substrate, in accordance with an embodiment of the present disclosure.

Referring to Figure 6A, a solar cell includes a silicon substrate 100 having a light-receiving surface 102. An intrinsic silicon layer 110 is disposed on the light-receiving surface 102 of the silicon substrate 100 (in this case, the growth may be epitaxial). An N-type silicon layer 112 is disposed on the intrinsic silicon layer 110. An anti-reflective coating (ARC) layer 114 is disposed on the N-type silicon layer 112. As such, the stack of layers on the light-receiving surface of the solar cell of Figure 6A does not include the passivating dielectric layer 108 described in association with Figure 3. Other features described in association with Figure 3, however, are similar. Furthermore, it is to be appreciated that emitter region may be formed within the substrate, as is described in association with Figure 4.

With reference again to Figure 6A, in a first embodiment, the intrinsic silicon layer 110 is an amorphous intrinsic silicon layer, and the N-type silicon layer 112 is a micro- or poly-crystalline N-type silicon layer. In a second embodiment, the intrinsic silicon layer 110 is a micro- or poly-crystalline intrinsic silicon layer, and the N-type silicon layer 112 is an amorphous N-type silicon layer. In a third embodiment, the intrinsic silicon layer 110 is a micro- or poly-crystalline intrinsic silicon layer, and the N-type silicon layer 112 is a micro- or poly-crystalline N-type silicon layer.

Figure 6B is an energy band diagram 600 for the second exemplary stack of layers disposed on a light-receiving surface of the solar cell described in association with Figure 6A, in accordance with an embodiment of the present disclosure. Referring to the energy band diagram 600, a band structure is provided for a material stack including N-type doped silicon (n), intrinsic silicon (i), and a crystalline silicon substrate (c-Si). The Fermi level is shown at 602 and reveals good passivation of the light-receiving surface of a substrate having this material stack even though an oxide layer is not in place to block pathway 604.

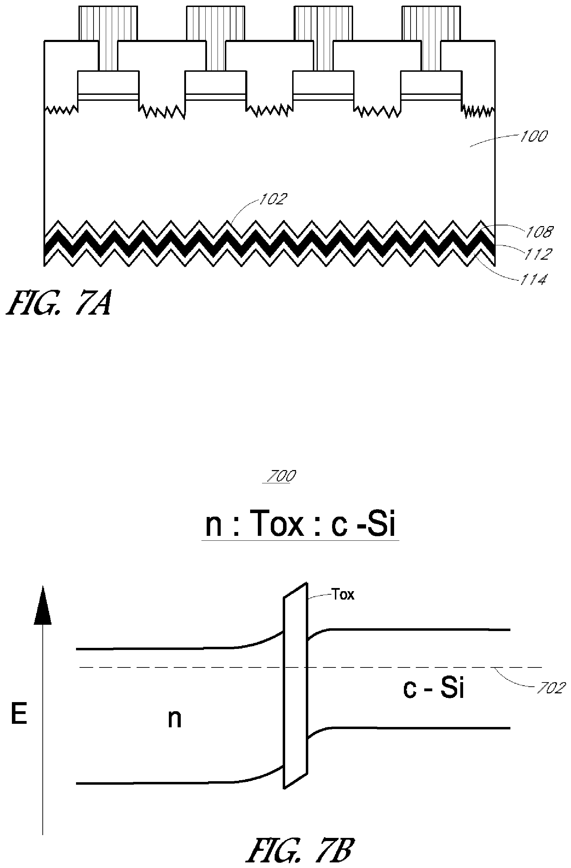

Figure 7A illustrates a cross-sectional view of a back-contact solar cell having emitter regions formed above a back surface of a substrate and having a third exemplary stack of layers on a light-receiving surface of the substrate. Figures 7A and 7B are not part of the present invention.

Referring to Figure 7A, a solar cell includes a silicon substrate 100 having a light-receiving surface 102. A passivating dielectric layer 108 is disposed on the light-receiving surface 102 of the silicon substrate 100. A micro- or poly-crystalline N-type silicon layer 112 is disposed on the passivating dielectric layer 108. An anti-reflective coating (ARC) layer 114 is disposed on the micro- or poly-crystalline N-type silicon layer 112. As such, the stack of layers on the light-receiving surface of the solar cell of Figure 7A does not include the micro- or poly-crystalline or amorphous intrinsic silicon layer 110 described in association with Figure 3. Other features described in association with Figure 3, however, are similar. Furthermore, it is to be appreciated that emitter region may be formed within the substrate, as is described in association with Figure 4.

Figure 7B is an energy band diagram 700 for the third exemplary stack of layers disposed on a light-receiving surface of the solar cell described in association with Figure 7A. Referring to the energy band diagram 700, a band structure is provided for a material stack including micro- or poly-crystalline N-type doped silicon (n), a thin oxide layer (Tox), and the crystalline silicon substrate (c-Si). The Fermi level is shown at 702 and reveals good passivation of the light-receiving surface of a substrate having this material stack.

In addition, it is to be understood that the substrate can be either n+ or p+ type material. Furthermore, it is to be understood that, where N+ and P+ type doping is described specifically for emitter regions on a back surface of a solar cell, other embodiments contemplated include the opposite conductivity type, e.g., P+ and N+ type doping, respectively. This may also be applied to front contact cells and bi-facial cell architectures.

Thus, methods of passivating light-receiving surfaces of solar cells with crystalline silicon, and the resulting solar cells, have been disclosed.

## Claims

1. A solar cell, comprising:
a silicon substrate (100) having a light-receiving surface (102);
**characterized by**
an intrinsic silicon layer (110) disposed above the light-receiving surface (102) of the silicon substrate (100); and
an N-type silicon layer (112) disposed on the intrinsic silicon layer (110), wherein one or both of the intrinsic silicon layer (110) and the N-type silicon layer (112) is a micro- or poly-crystalline silicon layer.

2. The solar cell of claim 1, wherein the N-type silicon layer (112) is an N-type micro- or poly-crystalline silicon layer having a crystalline fraction approximately in the range of 0.1-0.9, with the balance being amorphous.

3. The solar cell of claim 2, wherein a concentration of N-type dopants in the N-type micro- or poly-crystalline silicon layer (112) is approximately in the range of 1E17 - 1E20 atoms/cm³.

4. The solar cell of any one of claims 1 to 3, further comprising:
a passivating dielectric layer (108) disposed on the light-receiving surface (102) of the silicon substrate (100), wherein the intrinsic silicon layer (110) is disposed on the passivating dielectric layer (108).

5. The solar cell of claim 4, wherein the passivating dielectric layer (108) is a layer of silicon dioxide (SiO₂) having a thickness approximately in the range of 10-200 Angstroms.

6. The solar cell of any one of claims 1 to 5, further comprising:
an anti-reflective coating (ARC) layer (114) disposed on the N-type silicon layer (112).

7. The solar cell of any one of claims 1 to 6, wherein the light-receiving surface (102) has a texturized topography, and wherein both the intrinsic silicon layer (110) and the N-type silicon layer (112) are conformal with the texturized topography of the light-receiving surface (102).

8. The solar cell of any one of claims 1 to 7, wherein the substrate (100) further comprises a back surface (104) opposite the light-receiving surface (102), the solar cell further comprising:
a plurality of alternating N-type and P-type semiconductor regions (122, 120; 152, 150) at or above the back surface (104) of the substrate (100); and
a conductive contact structure (128/130, 158/160) electrically connected to the plurality of alternating N-type and P-type semiconductor regions (122, 120; 152, 150).

9. A method of fabricating a solar cell, the method comprising:
forming an intrinsic silicon layer (110) above a light-receiving surface (102) of a silicon substrate (100); and
forming an N-type silicon layer (112) on the intrinsic silicon layer (110), wherein one or both of the intrinsic silicon layer (110) and the N-type silicon layer (112) is a micro- or poly-crystalline silicon layer.

10. The method of claim 9, wherein the N-type silicon layer (112) is an N-type micro- or poly-crystalline silicon layer and forming the N-type micro- or poly-crystalline silicon layer comprises depositing an N-type amorphous silicon layer and, subsequently, phase converting the N-type amorphous silicon layer to the N-type micro- or poly-crystalline silicon layer.

11. The method of claim 9, wherein the N-type silicon layer (112) is an N-type micro- or poly-crystalline silicon layer and forming the N-type micro- or poly-crystalline silicon layer comprises depositing the N-type micro- or poly-crystalline silicon layer.

## Patentansprüche

1. Solarzelle, umfassend:
ein Siliciumsubstrat (100) mit einer lichtempfangenden Oberfläche (102);
**gekennzeichnet durch**
eine über der lichtempfangenden Oberfläche (102) des Siliciumsubstrats (100) angeordnete, intrinsische Siliciumschicht (110); und
eine Siliciumschicht vom N-Typ (112), die auf der intrinsischen Siliciumschicht (110) angeordnet ist, wobei eine oder beide der intrinsischen Siliciumschichten (110) und die Siliciumschicht vom N-Typ (112) eine mikro- oder polykristalline Siliciumschicht ist/sind.

2. Solarzelle nach Anspruch 1, wobei die Siliciumschicht vom N-Typ (112) eine mikro- oder polykristalline Siliciumschicht vom N-Typ mit einer Kristallfraktion ungefähr im Bereich von 0,1-0,9 mit amorphem Rest ist

3. Solarzelle nach Anspruch 2, wobei eine Konzentration von N-Typ-Dotierstoffen in der mikro- oder polykristallinen Siliciumschicht vom N-Typ (112) ungefähr im Bereich von 1E17-1EE20 Atomen/cm³ liegt.

4. Solarzelle nach einem der Ansprüche 1 bis 3, ferner umfassend:
eine auf der lichtempfangenden Oberfläche (102) des Siliciumsubstrats (100) angeordnete, dielektrische Passivierschicht (108), wobei die intrinsische Siliciumschicht (110) auf der dielektrischen Passivierschicht (108) angeordnet ist.

5. Solarzelle nach Anspruch 4, wobei es sich bei der dielektrischen Passivierschicht (108) um eine Schicht aus Siliciumdioxid (SiO₂) mit einer Dicke ungefähr im Bereich von 10-200 Angström handelt.

6. Solarzelle nach einem der Ansprüche 1 bis 5, ferner umfassend:
eine Antireflexionsbeschichtung (ARC-Schicht) (114), die auf der Siliciumschicht vom N-Typ (112) angeordnet ist.

7. Solarzelle nach einem der Ansprüche 1 bis 6, wobei die lichtempfangende Oberfläche (102) eine texturierte Topographie aufweist und wobei sowohl die intrinsische Siliciumschicht (110) als auch die N-Typ-Siliciumschicht (112) mit der texturierten Topographie der lichtempfangenden Oberfläche (102) übereinstimmt.

8. Solarzelle nach einem der Ansprüche 1 bis 7, wobei das Substrat (100) ferner eine Rückseitenoberfläche (104) gegenüber der lichtempfangenden Oberfläche (102) umfasst, wobei die Solarzelle ferner umfasst:
eine Vielzahl sich abwechselnder Halbleiterbereiche (122, 120; 152, 150) vom N-Typ und P-Typ an oder über der Rückseitenoberfläche (104) des Substrats (100); und
eine leitfähige Kontaktstruktur (128/130, 158/160), die elektrisch mit der Vielzahl von sich abwechselnden Halbleiterbereichen (122, 120; 152, 150) vom N-Typ und P-Typ verbunden ist.

9. Verfahren zum Herstellen einer Solarzelle, wobei das Verfahren aufweist:
das Bilden einer intrinsischen Siliciumschicht (110) über einer lichtempfangenden Oberfläche (102) eines Siliciumsubstrats (100); und
das Bilden einer Siliciumschicht vom N-Typ (112) auf der intrinsischen Siliciumschicht (110), wobei eine oder beide der intrinsischen Siliciumschichten (110) und die Siliciumschicht vom N-Typ (112) eine mikro- oder polykristalline Siliciumschicht ist/sind.

10. Verfahren nach Anspruch 9, wobei die Siliciumschicht vom N-Typ (112) eine mikro- oder polykristalline Siliciumschicht vom N-Typ ist und das Bilden der mikro- oder polykristallinen Siliciumschicht vom N-Typ das Abscheiden einer amorphen Siliciumschicht vom N-Typ und anschließend die Umwandlung der Phase der amorphen Siliciumschicht vom N-Typ in die mikro- oder polykristalline Siliciumschicht vom N-Typ umfasst.

11. Verfahren nach Anspruch 9, wobei die Siliciumschicht vom N-Typ (112) eine mikro- oder polykristalline Siliciumschicht vom N-Typ ist und das Bilden der mikro- oder polykristallinen Siliciumschicht vom N-Typ das Abscheiden der mikro- oder polykristallinen Siliciumschicht vom N-Typ umfasst.

## Revendications

1. Cellule solaire, comprenant :
un substrat de silicium (100) ayant une surface de réception de lumière (102) ;
**caractérisée par**
une couche de silicium intrinsèque (110) disposée au-dessus de la surface de réception de lumière (102) du substrat de silicium (100) ; et
une couche de silicium de type N (112) disposée sur la couche de silicium intrinsèque (110), dans laquelle l'une parmi la couche de silicium intrinsèque (110) et la couche de silicium de type N (112) ou les deux est une couche de silicium micro-cristalline ou poly-cristalline.

2. Cellule solaire selon la revendication 1, dans laquelle la couche de silicium de type N (112) est une couche de silicium de type N micro-cristalline ou poly-cristalline ayant une fraction cristalline comprise approximativement dans la plage de 0,1 à 0,9, le reste étant amorphe.

3. Cellule solaire selon la revendication 2, dans laquelle une concentration de dopants de type N dans la couche de silicium de type N (112) micro-cristalline ou poly-cristalline est comprise approximativement dans la plage de 1E17 à 1E20 atomes/cm³.

4. Cellule solaire selon l'une quelconque des revendications 1 à 3, comprenant en outre :
une couche diélectrique de passivation (108) disposée sur la surface de réception de lumière (102) du substrat de silicium (100), dans laquelle la couche de silicium intrinsèque (110) est disposée sur la couche diélectrique de passivation (108).

5. Cellule solaire selon la revendication 4, dans laquelle la couche diélectrique de passivation (108) est une couche de dioxyde de silicium (SiO₂) ayant une épaisseur comprise approximativement dans la plage de 10 à 200 Angströms.

6. Cellule solaire selon l'une quelconque des revendications 1 à 5, comprenant en outre :
une couche de revêtement anti-reflet (ARC) (114) disposée sur la couche de silicium de type N (112).

7. Cellule solaire selon l'une quelconque des revendications 1 à 6, dans laquelle la surface de réception de lumière (102) a une topographie texturée et dans laquelle la couche de silicium intrinsèque (110) et la couche de silicium de type N (112) sont conformes à la topographie texturée de la surface de réception de lumière (102).

8. Cellule solaire selon l'une quelconque des revendications 1 à 7, dans laquelle le substrat (100) comprend en outre une surface arrière (104) opposée à la surface de réception de lumière (102), la cellule solaire comprenant en outre :
une pluralité de régions semi-conductrices de type N et de type P (122, 120 ; 152, 150) alternées au niveau de la surface arrière (104) du substrat (100) ou au-dessus d'elle ; et
une structure de contact conductrice (128/130, 158/160) reliée électriquement à la pluralité de régions semi-conductrices de type N et de type P (122, 120 ; 152, 150) alternées.

9. Procédé de fabrication d'une cellule solaire, le procédé comprenant :
la formation d'une couche de silicium intrinsèque (110) au-dessus d'une surface de réception de lumière (102) d'un substrat de silicium (100) ; et
la formation d'une couche de silicium de type N (112) sur la couche de silicium intrinsèque (110), dans laquelle l'une parmi la couche de silicium intrinsèque (110) et la couche de silicium de type N (112) ou les deux est une couche de silicium micro-cristalline ou poly-cristalline.

10. Procédé selon la revendication 9, dans lequel la couche de silicium de type N (112) est une couche de silicium de type N micro-cristalline ou poly-cristalline et la formation de la couche de silicium de type N micro-cristalline ou poly-cristalline comprend le dépôt d'une couche de silicium amorphe de type N et, par la suite, la conversion par phase de la couche de silicium de type N amorphe en une couche de silicium de type N micro-cristalline ou poly-cristalline.

11. Procédé selon la revendication 9, dans lequel la couche de silicium de type N (112) est une couche de silicium de type N micro-cristalline ou poly-cristalline et la formation de la couche de silicium de type N micro-cristalline ou poly-cristalline comprend le dépôt de la couche de silicium de type N micro-cristalline ou poly-cristalline.
